# EUROPEAN PATENT APPLICATION

(11) **EP 4 603 877 A1**
(43) Date of publication of application: **20.08.2025**
(21) Application number: 23877550.6
(22) Date of filing: 22.09.2023
(51) Int. Cl.: G01T 1/24, G01T 1/161, H01L 31/08, H01L 27/146

(54) **X-RAY DETECTOR**

(30) Priority: 13.10.2022 KR 20220131379
(71) Applicant: DRTECH CORP, Seongnam-Si, Gyeonggi-do 13216 (KR)
(72) Inventor: MOON, Beom Jin, Suwon-si Gyeonggi-do 16707 (KR); KIM, Hyeong Sik, Hwaseong-si Gyeonggi-do 18489 (KR); GIL, Yong Cheol, Suwon-si Gyeonggi-do 16571 (KR); PARK, Jong Yoon, Seongnam-si Gyeonggi-do 13357 (KR)
(74) Representative: Jung, Minkyu
(86) International application number: PCT/KR2023/014499
(87) International publication number: WO 2024/080622

(57) **Abstract**

This X-ray detector which detects an X-ray and generates a corresponding output signal comprises: a TFT array including a plurality of pixel TFT circuits each generating the output signal according to the intensity of the detected X-ray; a gate circuit configured to apply, to the TFT array, a gate signal for driving the plurality of pixel TFT circuits; and a readout circuit configured to receive the output signal generated by each of the plurality of pixel TFT circuits and transmit the output signal to the outside. The gate circuit comprises: a gate chip-on film configured to generate the gate signal and apply the gate signal to the TFT array; and a gate connection FPCB circuitly connected to the gate chip-on film so as to receive a driving signal for generating the gate signal and transmit the driving signal to the gate chip-on film. The gate chip-on film and the gate connection FPCB are respectively arranged along different sides of the X-ray detector.

## Description

### [Technical Field]

The present invention relates to an X-ray detector.

### [Background Art]

X-ray imaging devices that use X-rays to obtain internal images of objects are used in various fields such as the medical and industrial fields. An X-ray imaging device includes an X-ray source for generating X-rays and an X-ray detector for detecting X-rays that have passed through objects.

The X-ray detector detects X-rays that have passed through an object in units of pixels and generates an electrical signal according to the intensity of the detected X-rays. For example, the X-ray detector includes an electric charge generation layer that generates electric charges according to the intensity of detected X-rays, and a thin film transistor (TFT) array layer including a plurality of TFTs arranged in the form of a matrix to generate an electrical signal according to the amount of the generated electric charges. Meanwhile, the TFT array layer requires a gate circuit for inputting a gate signal for driving each TFT, and a readout circuit for outputting a readout signal which is an output signal. The gate circuit is formed so that a driving signal is received from a controller, a gate signal for driving each TFT is generated according to the received driving signal, and the generated gate signal is applied to each TFT. Such a gate circuit may be implemented in the form of a gate board or a gate chip-on-film (COF). There is a problem in that the gate board is large in size, making it difficult to realize a miniaturized design, and in particular, when the gate board is applied to the X-ray detector, the X-ray detector cannot be implemented in the form of a flexible detector. In order to solve such a problem, a technology for replacing a gate board with a gate COF and a gate connection flexible printed circuit board (FPCB) that is circuit-coupled to the gate COF has been introduced.

A gate connection FPCB receives a driving signal from an external driving circuit and transmits the received driving signal to a gate COF, and the gate COF generates a gate signal using the driving signal transmitted from the gate connection FPCB and applies the generated gate signal to each TFT. In this case, the gate connection FPCB should be formed relatively long compared to the gate COF for connection with the external driving circuit and should also have a connector for circuit connection with the external driving circuit, and thus the gate connection FPCB has a relatively large length. A readout circuit, for example, a readout COF, is formed along one side of a TFT detector and the gate COF and the gate connection FPCB are formed together along another side of the TFT detector in a direction in which the gate COF and the gate connection FPCB are formed becomes large, and thus it is difficult to design a smaller size. Further, since the gate connection FPCB is formed together with a relatively compact gate COF, this results in offsetting the miniaturization potential resulting from the application of a compact gate COF.

### [Related Art Document]

### [Patent Document]

(Patent Document 1) Korean Laid-open Patent Publication No. 10-1139408 (Published on April 27, 2012)

### [Disclosure]

### [Technical Problem]

The present invention is directed to providing an X-ray detector that allows a miniaturized design by optimizing the structure of a connector of a thin film transistor and is capable of performing imaging by being effectively in close contact with an object such as a pipe.

### [Technical Solution]

One aspect of the present invention provides an X-ray detector for detecting X-rays to generate a corresponding output signal, which includes a thin film transistor (TFT) array including a plurality of pixel TFT circuits, each of which generates the output signal according to intensity of the detected X-rays, a gate circuit configured to apply a gate signal for driving the plurality of pixel TFT circuits to the TFT array, and a readout circuit configured to receive the output signals generated by the plurality of pixel TFT circuits and transmit the received output signals to an external device. The gate circuit includes a gate chip-on-film configured to generate the gate signal and apply the generated gate signal to the TFT array, and a gate connection flexible printed circuit board (FPCB) that is circuit-coupled to the gate chip-on-film to receive a driving signal for generating the gate signal and transmit the received driving signal to the gate chip-on-film. The gate chip-on-film and the gate connection FPCB are disposed along different sides of the X-ray detector.

The gate connection FPCB may be disposed along a side of the X-ray detector that is the same as a side on which the readout circuit is disposed.

The gate chip-on-film may be disposed along one side of the X-ray detector, and the gate connection FPCB and the readout circuit may be disposed together along a side adjacent to the one side of the X-ray detector on which the gate chip-on-film is disposed.

The readout circuit may be formed of a readout chip-on-film.

The X-ray detector may be formed as a flexible detector that is bendable.

Another aspect of the present invention provides an X-ray detector which includes a TFT array including a plurality of pixel TFT circuits, each of which generates an output signal according to intensity of detected X-rays, a gate circuit configured to apply a gate signal for driving the plurality of pixel TFT circuits to the TFT array, and a readout circuit configured to read the output signals and transmit the read output signals to an external device. The gate circuit includes a gate connection circuit that receives a driving signal from an external device, and a gate signal generation circuit that receives the driving signal from the gate connection circuit and generates the gate signal. The TFT array is configured to form a quadrangular area. The gate connection circuit and the readout circuit are disposed together along one side of the quadrangular area of the TFT array, and the gate signal generation circuit is disposed along a side adjacent to the one side of the quadrangular area along which the gate connection circuit and the readout circuit are disposed.

The gate connection circuit may have the form of a FPCB, and the readout circuit and the gate signal generation circuit may each have the form of a chip-on-film.

### [Advantageous Effects]

According to the present invention, by spatially separating a gate connection flexible printed circuit board (FPCB) from a gate chip-on-film and arranging the gate connection FPCB and a readout chip-on-film along one side of a thin film transistor (TFT) X-ray detector, parts can be disposed without interference when designing printed circuit boards, and a miniaturized X-ray detector can be designed.

Further, by spatially separating a relatively long gate connection FPCB from a relatively short gate chip-on-film and positioning the relatively long gate connection FPCB along another side, a length of a portion extending outward from a TFT X-ray detector in a direction in which the gate chip-on-film is formed can be minimized, thereby allowing a TFT X-ray detector to be in maximum close contact with an object such as a pipe and enabling effective imaging.

### [Description of Drawings]

FIG. 1 is a cross-sectional view schematically illustrating a direct conversion type X-ray detector according to one embodiment of the present invention.
FIG. 2 is a cross-sectional view schematically illustrating an indirect conversion type X-ray detector according to another embodiment of the present invention.
FIG. 3 is a schematic view illustrating an X-ray detector according to one embodiment of the present invention.

### [Best Mode of the Invention]

Hereinafter, embodiments of the present invention that can be easily performed by those skilled in the art will be described in detail with reference to the accompanying drawings. However, embodiments of the present invention may be implemented in several different forms and are not limited to embodiments described herein.

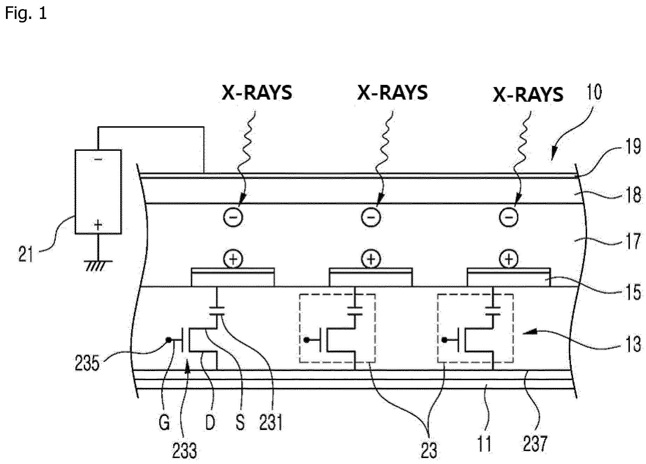

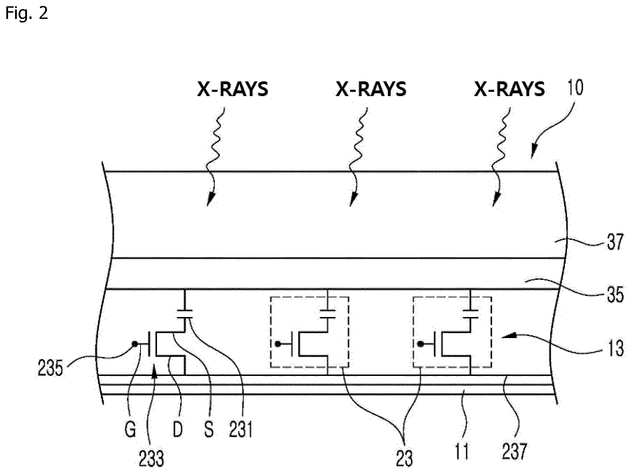

An X-ray detector according to one embodiment of the present invention may be a direct conversion type X-ray detector or an indirect conversion type X-ray detector. FIG. 1 illustrates an example of a direct conversion type X-ray detector, and FIG. 2 illustrates an example of an indirect conversion type X-ray detector.

Referring to FIG. 1, an X-ray detector 10 according to one embodiment of the present invention may be a digital X-ray detector that directly converts photons of X-rays into electric charges, that is, a direct conversion type X-ray detector. Further, the X-ray detector 10 according to the embodiment of the present invention may be a flexible X-ray detector that can be bent.

Referring to FIG. 1, in the X-ray detector 10 according to the embodiment of the present invention, a thin film transistor (TFT) array 13, an electric charge collector 15, a photoconductor layer 17, and an upper electrode 19 may be sequentially formed on a bendable substrate 11. For example, the substrate 11 may be formed of a bendable synthetic resin material, and thus the X-ray detector 10 according to the embodiment of the present invention may be formed as a flexible detector.

When X-rays are incident on the upper electrode 19 while a high voltage of a power source 21 is applied, the photoconductor layer 17 generates electric charges. The photoconductor layer 17 may be formed of a material that directly converts photons of X-rays into electric charges, that is, a photoconductor, such as amorphous selenium, lead oxide (PbO), mercury iodide (HgI₂), thallium bromide, etc. In this case, the electrical insulation layer 18 is formed between the upper electrode 19 and the photoconductor layer 17, and thus the upper electrode 19 and the photoconductor layer 17 may be electrically insulated from each other.

The TFT array 13 may include a plurality of pixel TFT circuits 23 and may be formed in the form of a flexibility panel. As is generally known, the plurality of pixel TFT circuits 23 may be disposed in the form of a matrix in units of pixels, thereby allowing the TFT array 13 to form a quadrangular area. Each pixel TFT circuit 23 includes a storage capacitor 231 and a TFT switching element 233. The TFT switching element 233 includes a gate terminal G, a data terminal D, and a source terminal S, and the source terminal S is coupled to the storage capacitor 231. The gate terminal G is signal-coupled to a gate circuit, that is, a gate chip-on-film (COF) 311, through a gate line 235, and the data terminal D is signal-coupled to a readout circuit, that is, a readout integrated circuit (IC) COF 33, through a data line 237.

When electric charges are generated in the photoconductor layer 17 by incident X-rays, positive electric charges among the generated electric charges are collected in the electric charge collector 15. Furthermore, the positive electric charges collected in the electric charge collector 15 are stored in the storage capacitor 231 of the pixel TFT circuit 23. Since an amount of electric charges generated by the photoconductor layer 17 varies according to the intensity of the incident X-rays in this process, the amount of electric charges stored in the storage capacitor 231 as a result varies according to the intensity of the X-rays. When a gate signal, that is, a scan signal, is applied to the gate terminal G through the gate line 235, the TFT switching element 233 is turned on, and thus an output signal corresponding to the amount of electric charges stored in the storage capacitor 231 is output to the data line 237 through the data terminal D. An output signal corresponding to the intensity of X-rays detected for each pixel is output in this way, and this output signal may be used to generate an X-ray image. Meanwhile, although not illustrated in the drawing, as is generally known, a circuit element for initializing the storage capacitor 231 after outputting the output signal by turning on the TFT switching element 233, for example, a switching element, may be coupled to the storage capacitor 231 in parallel.

Meanwhile, referring to FIG. 2, an X-ray detector 10 according to another embodiment of the present invention may be an indirect conversion type digital X-ray detector that converts X-rays into visible light and then changes photons of the visible light into electric charges. The same portions as the direct conversion type X-ray detector described above with reference to FIG. 1 are used with the same drawing reference numerals and the description thereof will not be repeated.

Referring to FIG. 2, the indirect conversion type X-ray detector 10 includes a scintillator layer 37 that converts incident X-rays into visible light, and a photodiode layer 35 that generates electric charges in the visible light converted by the scintillator layer 37. The scintillator layer 37 may be formed as a scintillator that emits visible light proportional to incident X-rays. The photodiode layer 35 may be formed as an amorphous silicon photodiode and converts visible light emitted from the scintillator layer 37 into electric charges. As in the previously described embodiment, the electric charges generated in the photodiode layer 35 are detected by a TFT array 13.

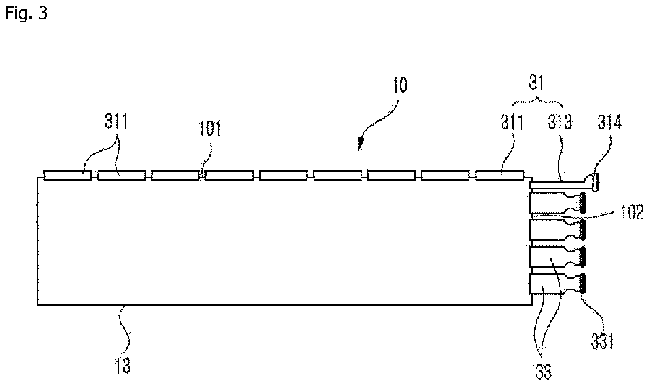

Hereinafter, a gate circuit 31 for applying a gate signal to a gate line 235, and a readout circuit 33 for receiving an output signal from a data line 237 and outputting the received output signal to an outside thereof will be described with reference to FIG. 3.

FIG. 3 illustrates a plan view of an example of the TFT array 13 of the X-ray detector 10, and the TFT array 13 may have an overall quadrangular shape. As described above, the TFT array 13 includes a plurality of pixel TFT circuits 23 arranged in the form of a matrix.

The gate circuit 31 is configured to apply a gate signal to the gate line 235 coupled to the pixel TFT circuit 23. According to the embodiment of the present invention, the gate circuit 31 is divided into two parts, that is, a gate COF 311 and a gate connection flexible printed circuit board (FPCB) 313, and the gate COF 311 and the gate connection FPCB 313 are respectively disposed along different sides 101 and 102 of the X-ray detector 10. Here, the sides of the X-ray detector 10 may also be understood as the sides of a quadrangular area of the TFT array 13. The gate connection FPCB 313 is signal-coupled to an external controller through a connector 314, receives a driving signal from the external controller, and transmits the received driving signal to the gate COF 311, and the gate COF 311 generates a gate signal according to the received driving signal and applies the generated gate signal to the gate line 235.

The readout circuit 33 is implemented in the form of a COF, and therefore, the readout circuit 33 may be called a readout COF. The readout COF 33 may be coupled to an external image signal processor through a connector 331 and transmit an output signal to the image signal processor.

According to the embodiment of the present invention, the readout COF 33 may be disposed along one side of the X-ray detector 10. In this case, the gate COF 311 of the gate circuit 31 may be disposed along one side 101 of the X-ray detector 10 having a quadrangular shape, and the gate connection FPCB 313 of the gate circuit 31 and the readout COF 33 may be disposed along a side 102 adjacent to the one side 101 of the X-ray detector 10 along which the gate COF 311 is disposed. According to the embodiment of the present invention, considering that the gate connection FPCB 313 and the readout COF 33 should be formed relatively long in order to be signal-coupled to an external controller or image signal processor and should include the connectors 314 and 331 for coupling, the gate connection FPCB 313 and the readout COF 33 may be disposed on one side 102 so that the size of the X-ray detector 10 in a height direction, that is, in a vertical direction in FIG. 3, can be significantly reduced. Accordingly, since the gate COF 311 forms a portion protruding outward from the TFT array 13 in the height direction of the X-ray detector 10, the length in the height direction of the portion protruding outward from the TFT array 13, which is an X-ray detection area, may be minimized. This means that the X-ray detector 10 may approach an object very closely in the height direction, thereby enabling imaging to be performed with the X-ray detector 10 positioned very close to a coupling part of a T-shaped pipe. Further, the gate COF 311 and the gate connection FPCB 313 may be disposed along different sides of the X-ray detector and thus may be prevented from interfering with each other.

Although an example of the direct conversion type X-ray detector has been described above, it can be recognized that the present invention may also be applied to an indirect conversion type X-ray detector having a TFT array. Further, the X-ray detector according to one embodiment of the present invention may be implemented as a flexible detector that can be bent as described above or may be a rigid type X-ray detector in which a TFT is formed on a glass substrate.

While embodiments have been described above in detail, the scope of embodiments of the present invention is not limited thereto but encompasses several modifications and improvements by those skilled in the art using basic concepts of embodiments of the present invention defined by the appended claims.

### [Reference Numerals]

10: X-ray detector
11: substrate
13: TFT array
15: electric charge collector
17: photoconductor layer
18: electrical insulation layer
19: upper electrode
21: power source
23: pixel TFT circuit
231: storage capacitor
233: TFT switching element
G: gate terminal
S: source terminal
D: data terminal
235: gate line
237: data line
31: gate circuit
33: readout circuit
311: gate chip-on-film
313: gate connection FPCB
314: connector
331: connector
101, 102: sides of X-ray detector

## Claims

1. An X-ray detector for detecting X-rays to generate a corresponding output signal, comprising:
a thin film transistor (TFT) array including a plurality of pixel TFT circuits, each of which generates the output signal according to intensity of the detected X-rays;
a gate circuit configured to apply a gate signal for driving the plurality of pixel TFT circuits to the TFT array; and
a readout circuit configured to receive the output signals generated by the plurality of pixel TFT circuits and transmit the received output signals to an external device,
wherein the gate circuit includes:
a gate chip-on-film configured to generate the gate signal and apply the generated gate signal to the TFT array, and
a gate connection flexible printed circuit board (FPCB) that is circuit-coupled to the gate chip-on-film to receive a driving signal for generating the gate signal and transmit the received driving signal to the gate chip-on-film, and
wherein the gate chip-on-film and the gate connection FPCB are disposed along different sides of the X-ray detector.

2. The X-ray detector of claim 1, wherein the gate connection FPCB is disposed along a side of the X-ray detector that is the same as a side on which the readout circuit is disposed.

3. The X-ray detector of claim 2, wherein the gate chip-on-film is disposed along one side of the X-ray detector, and
the gate connection FPCB and the readout circuit are disposed together along a side adjacent to the one side of the X-ray detector on which the gate chip-on-film is disposed.

4. The X-ray detector of claim 3, wherein the readout circuit is formed of a readout chip-on-film.

5. The X-ray detector of claim 1, wherein the X-ray detector is formed as a flexible detector that is bendable.

6. An X-ray detector comprising:
a thin film transistor (TFT) array including a plurality of pixel TFT circuits, each of which generates an output signal according to intensity of detected X-rays;
a gate circuit configured to apply a gate signal for driving the plurality of pixel TFT circuits to the TFT array; and
a readout circuit configured to read the output signals and transmit the read output signals to an external device,
wherein the gate circuit includes a gate connection circuit that receives a driving signal from an external device, and a gate signal generation circuit that receives the driving signal from the gate connection circuit and generates the gate signal,
the TFT array is configured to form a quadrangular area,
the gate connection circuit and the readout circuit are disposed together along one side of the quadrangular area of the TFT array, and
the gate signal generation circuit is disposed along a side adjacent to the one side of the quadrangular area along which the gate connection circuit and the readout circuit are disposed.

7. The X-ray detector of claim 6, wherein the gate connection circuit is formed to have a form of a flexible printed circuit board (FPCB), and
each of the readout circuit and the gate signal generation circuit has a form of a chip-on-film.
